Europäisches Patentamt

European Patent Office

Office européen des brevets

(11) Veröffentlichungsnummer: **0 421 320 A2**

# (12) EUROPÄISCHE PATENTANMELDUNG

(21) Anmeldenummer: 90118800.3

(22) Anmeldetag: 01.10.90

(51) Int. Cl.⁵: **G01R 11/02**

(30) Priorität: 06.10.89 DE 3933356

(43) Veröffentlichungstag der Anmeldung:
**10.04.91 Patentblatt 91/15**

(84) Benannte Vertragsstaaten:
**AT BE CH DE LI NL SE**

(71) Anmelder: **Licentia Patent-Verwaltungs-GmbH**
**Theodor-Stern-Kai 1**
**W-6000 Frankfurt/Main 70(DE)**

(72) Erfinder: **Hoffmann, Horst, Ing.(grad.)**
**Schulstrasse 60**
**W-3250 Hameln 5(DE)**

Erfinder: **Blumenthal, Eckhard**
**Ohrbergpark 1**
**W-3254 Emmerthal 8(DE)**
Erfinder: **Brüggemann, Friedrich, Ing.(grad.)**
**Ostpreussenweg 9**
**W-3250 Hameln(DE)**
Erfinder: **Sleur, Dieter, Dipl.-Ing.**
**Über den Eichen 6**
**W-3253 Hess. Oldendorf 15(DE)**

(74) Vertreter: **Vogl, Leo, Dipl.-Ing.**
**Licentia Patent-Verwaltungs-G.m.b.H.**
**Theodor-Stern-Kai 1**
**W-6000 Frankfurt 70(DE)**

(54) **Elektrizitätszähler.**

(57)

2.1. Der Elektrizitätszähler hat ein aus einer Grundplatte (1) und einer Gehäusekappe (2) zusammengesetztes Zählergehäuse (3). Dieses nimmt in seinem Innenraum (3a) ein der Beglaubigungspflicht unterliegendes Zählermeßwerk auf. Es sollen der Beglaubigungspflicht nicht unterliegende Zusatzgeräte raumsparend am Zählergehäuse (3) so untergebracht werden, daß die Eichgültigkeit des Elektrizitätszählers auch bei einer Nachrüstung oder Überholung der Zusatzgeräte erhalten bleibt.

2.2. Zu diesem Zweck ist die Gehäusekappe (2) in einem Teilbereich mit einer in den Innenraum (3a) des Zählergehäuses (3) eintauchenden Kammer (2b) versehen. Diese ist zum Innenraum (3a) hin geschlossen und an der Vorderseite des Zählergehäuses (3) von außen her zugänglich. Nach dem Einbau der Zusatzgeräte (5) ist die Kammer (2b) mit einem Abdeckteil (4) verschließbar. Die zum Innenraum (3a) hin geschlossene Kammer (2b) kann unmittelbar durch eine in die Gehäusekappe (2) eingeformte Trennwand (2c) gebildet sein, sie kann jedoch auch als separates Teil hergestellt sein, das in einem Ausschnitt der Gehäusekappe (2) selbsthaltend eingesetzt ist.

2.3. Insbesondere bei einem Drehstrom-Elektrizitätszähler eignet sich die in die Gehäusekappe (2) integrierte separate Kammer (2b) zum Einbau von elektronischen Steuer-und Kommunikationsbausteinen wie einem Rundsteuerempfänger, einem Tarifschaltuhrenbaustein, einem Temex-Modul, einem Bus-Anschlußsystem oder ähnlicher zusätzlicher Tarifgeräte.

Fig. 2

## ELEKTRIZITÄTSZÄHLER

Die Erfindung betrifft einen Elektrizitätszähler mit einem aus einer Grundplatte und einer Gehäusekappe zusammengesetzten Zählergehäuse, das in seinem Innenraum ein der Beglaubigungspflicht unterliegendes Meßwerk aufnimmt, und mit einem am Zählergehäuse angesetzten Zusatzgehäuse, welches der Beglaubigungspflicht nicht unterliegende Tarifgeräte oder Baugruppen enthält, die ihrerseits in Wirkverbindung mit dem Meßwerk befindlich sind.

Aus der DE 27 12 918 B2 ist ein Elektrizitätszähler bekannt, bei dem ein in einem Zusatzgehäuse befindliches Sonderzählwerk mechanisch mit dem Zählermeßwerk verbunden ist. Dabei wird das durch einen Schlitz des Zählergehäuses greifende Sonderzählwerk von der Läuferwelle direkt angetrieben. Zur Unterbringung des Zusatzgehäuses ist die Gehäusekappe im oberen Bereich mit einem stufenförmigen Absatz versehen, über den zur Befestigung und zum Antrieb des Sonderzählwerkes dienende Bauteile des Meßwerkes von außen her frei zugänglich sind. Eine Änderung oder Störung bei dieser Anordnung macht zumeist Eingriffe am Meßwerk notwendig, die den Verlust der Eichgültigkeit des Elektrizitätszählers nach sich ziehen.

Der Erfindung liegt die Aufgabe zugrunde, einen Elektrizitätszähler der eingangs genannten Art so auszugestalten, daß Tarifgeräte und/oder andere Zusatzbausteine unter besonderer Berücksichtigung eichrechtlicher Vorschriften platzsparend und raumökonomisch untergebracht werden können und dadurch verschiedenartige flexible Anordnungen von Tarifeinrichtungen möglich sind, die zudem einen wesentlich verringerten Überholungsaufwand ohne erneute Beglaubigungsprüfung erfordern.

Diese Aufgabe wird durch einen Elektrizitätszähler mit den kennzeichnenden Merkmalen des Patentanspruchs 1 gelöst. Weiterbildungen und vorteilhafte Ausgestaltungen der Erfindung sind in den Unteransprüchen angegeben.

Die Erfindung hat den Vorteil, daß durch Integration einer zusätzlichen geschlossenen Kammer innerhalb der Gehäusekappe unter Einhaltung der üblichen Hüllmaße des Zählergehäuses Platz für Zusatzgeräte geschaffen ist. So lassen sich in der Kammer Steuer- und Kommunikationsbausteine wie beispielsweise ein Rundsteuerempfänger, ein Tarifschaltuhrenbaustein, ein Temex-Modul oder ein Bus-Anschlußsystem unterbringen, die gegebenenfalls auch am Einbauort des Elektrizitätszählers nachträglich eingebaut oder ausgetauscht werden können, ohne daß dieser seine Beglaubigung verliert. Auch beim Einbau von Tarifgeräten, die im Rahmen der Beglaubigungsprüfung gemeinsam mit dem Basiszähler zu messen sind, erfordert die erfindungsgemäße Anordnung einen wesentlich geringeren Überholungs- und gegebenenfalls Reparaturaufwand da der Elektrizitätszähler weiterhin geschlossen bleibt. Meßtechnische Veränderungen treten bei einem solchen Vorgang nicht auf, so daß die erneut notwendige Beglaubigungsprüfung erheblich erleichtert ist. Ein mit dem nicht vertieften Teil der Gehäusekappe oberflächenbündig angeordnetes Abdeckteil gibt dem Zählergehäuse formal ein gleichmäßiges Aussehen, wobei durch geeignete Werkstoffwahl der Kammer oder auch des Abdeckteiles eine Abtastung des Zählerläufers trotz räumlicher Trennung ermöglicht wird. Als weiterer Vorteil lassen sich in der Kammer Steckverbindungen direkt zum Zählerinneren anordnen, die beispielsweise mit ausreichend Spiel in einem Durchsteckschlitz geführt und mit einer Labyrinthdichtung abgedeckt sind. Eine solche mehrpolige Steckverbindung in der Kammer ist gleichbedeutend mit der Funktion von Zusatzklemmen und ermöglicht den elektrischen Anschluß zwischen dem in der Kammer befindlichen Zusatzgerät und dem Meßwerk sowie den Baugruppen innerhalb des umschlossenen Zählergehäuses.

Anhand der Zeichnung ist die Erfindung an einem Ausführungsbeispiel nachstehend näher erläutert.

Fig. 1 zeigt vereinfacht die Frontansicht eines Drehstrom-Zählergehäuses, während

Fig. 2 einen Schnitt durch den Elektrizitätszähler gemäß der Linie II-II schematisch vereinfacht wiedergibt.

Der Elektrizitätszähler hat ein aus einer Grundplatte (1) und einer Gehäusekappe (2) zusammengesetztes Zählergehäuse (3), welches in seinem geschlossenen Innenraum (3a) ein nicht gezeigtes, an der Grundplatte befestigtes Drehstrom-Meßwerk aufnimmt. Dieses Meßwerk, vorzugsweise nach dem Induktionsprinzip mit auf einen Zählerläufer wirkenden Triebsystemen, einem oder mehreren Zählwerken und gegebenenfalls weiteren im Zählerbau üblichen Funktionsgruppen wird vom Hersteller des Elektrizitätszählers eingestellt sowie beglaubigt und nach Aufsetzen der Gehäusekappe mittels Plombierschrauben (3b) gegen unbefugten Eingriff geschützt. Ein mit der Gehäusekappe fest verbundenes transparentes Sichtfenster (2a) gibt dabei den Einblick auf ein Typenschild frei, welches auf bekannte Art bedruckt und mit Ausschnitten (2a') wie angedeutet versehen ist.

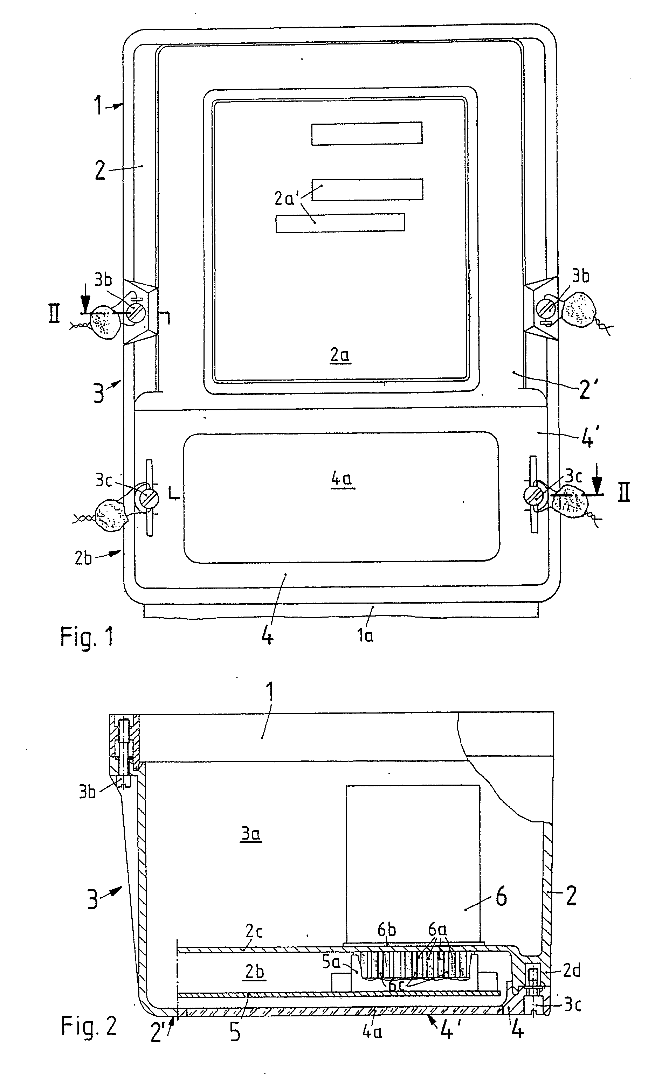

Unterhalb des Sichtfensters (2a) ist in der Gehäusekappe etwa über deren gesamte Breite vertieft eine Kammer (2b) eingeformt, die zum Innenraum hin mittels einer Trennwand (2c) berührungssicher abgeschottet ist und dabei den über dem Meßwerk verbleibenden Freiraum nutzt. Die in Fig. 2 gezeigte ebene Trennwand (2c) ist daher nur schematisch dargestellt. Beim fertigen Elektrizitätszähler ist die Trennwand vorzugsweise stufig dem vorhandenen Freiraum optimal angepaßt, so daß zumindest teilweise als Tiefe der Kammer (2b) nahezu die halbe Gehäusekappenhöhe genutzt werden kann. Die Kammer ihrerseits ist von einer labyrinthartigen Randausbildung (2d) umgeben und mit einem darauf aufliegenden, angepaßten Abdeckteil (4) verschlossen, welches die Außenkonturen der Gehäusekappe nahezu oberflächenbündig vervollständigt. Dabei bilden die Frontseite (4') des mit einem transparenten Fenster (4a) versehenen Abdeckteiles und der erhabene Bereich (2') der Gehäusekappe vorzugsweise eine ebene glatte Fläche und entsprechen daher räumlich sowie optisch etwa einem herkömmlichen Zählergehäuse. Insbesondere bleibt ein von der Gehäusekappe nicht überdeckter Klemmenblockbereich (1a) an der dort vorstehenden Grundplatte (1) wie bisher ungehindert zugänglich.

In der Kammer (2b) lassen sich vorzugsweise elektronische Zusatzgeräte unterbringen, beispielsweise ein durch eine Leiterplatte (5) angedeuteter Rundsteuerempfänger. Damit dieser in Wirkverbindung mit dem Meßwerk des Elektrizitätszählers treten kann, ist innerhalb des plombierten Innenraumes (3a) eine lediglich schematisch angedeutete, verschiedene Funktionen erfüllende Schaltungsplatine (6) befestigt. Diese ist beispielsweise mit Kontaktflächen (6a) versehen und in einem Durchsteckschlitz in der Trennwand (2c) geführt mit den Kontaktflächen in Richtung der Kammer vorstehend angeordnet. Ein rahmenartiges, an den Durchsteckschlitz angepaßtes Dichtelement (6b) liegt eng an der Schaltungsplatine (6) an und ist durch nicht gezeigte Querstege, die beispielsweise über schlitzförmige Ausnehmungen (6c) zwischen den Kontaktflächen (6a) einschiebbar sind, stabilisiert. Nach Aufsetzen der Gehäusekappe (2) bildet das Dichtelement (6b) ein unverschiebliches Labyrinth um den Durchsteckschlitz, so daß der Innenraum (3a) gegen die Kammer (2b) im Sinne eichrechtlicher Vorschriften dicht abgeschlossen ist.

Bei einem so vorbereiteten beglaubigten Elektrizitätszähler läßt sich auf die vorstehenden Kontaktflächen (6a) ein Steckverbinder (5a) der Leiterplatte (5) aufschieben, so daß der elektrische Anschluß zwischen der Schaltungsplatine (6) und dem Rundsteuerempfänger hergestellt ist. An seiner Stelle lassen sich in der Kammer auf die gleiche Art beispielsweise auch ein Tarifschaltuhrenbaustein, ein Temex-Modul oder ein Bus-Anschlußsystem unterbringen. Abschließend wird das Abdeckteil (4) aufgesetzt und vom Hersteller des Elektrizitätszählers oder auch vom EVU durch weitere Plombierschrauben (3c) vor unbefugtem Zugriff gesichert.

Anstelle der fest mit der Gehäusekappe verbundenen Trennwand (2c) läßt sich auch ein separates Teil, beispielsweise aus transparentem Werkstoff herstellen, und in einen Ausschnitt der Gehäusekappe so einsetzen, daß ein Teil des Innenraumes des umschlossenen Zählergehäuses - wie vorstehend beschrieben - als besondere Kammer für Zusatzgeräte nutzbar ist. Des weiteren ist die Lage der Kammer, die - wie in Fig. 1 gezeigt - etwa ein Drittel der Gehäusefrontfläche einnimmt, nicht auf das Ausführungsbeispiel begrenzt, sondern diese kann auch ebenso in der Gehäusemitte zwischen den üblicherweise zwei Triebscheiben oder auch an der Oberseite des Zählergehäuses angeordnet sein. In jedem Fall bleibt der Klemmenblockbereich (1a) frei, so daß hier beispielsweise zusätzlich ein elektronisches Maximumwerk angeordnet werden kann.

## Ansprüche

1. Elektrizitätszähler mit einem aus einer Grundplatte und einer Gehäusekappe zusammengesetzten Zählergehäuse, das in seinem Innenraum ein der Beglaubigungspflicht unterliegendes Meßwerk aufnimmt, und mit einem am Zählergehäuse angesetzten Zusatzgehäuse, welches der Beglaubigungspflicht nicht unterliegende Tarifgeräte oder Baugruppen enthält, die ihrerseits in Wirkverbindung mit dem Meßwerk befindlich sind, dadurch gekennzeichnet, daß die Gehäusekappe (2) in einem Teilbereich mit einer in das Innere des Zählergehäuses (3) eintauchenden Kammer (2b) versehen ist, die zum Innenraum (3a) hin geschlossen und an der Vorderseite des Zählergehäuses (3) von außen her zugänglich zum Einbau von Zusatzgeräten (Leiterplatte 6) ausgebildet sowie mit einem Abdeckteil (4) verschließbar ist.

2. Elektrizitätszähler nach Anspruch 1, dadurch gekennzeichnet, daß die Kammer (2b) unmittelbar in die Gehäusekappe (2) eingeformt ist.

3. Elektrizitätszähler nach Anspruch 1, dadurch gekennzeichnet, daß die Kammer (2b) als separates Teil ausgebildet und danach in einem Ausschnitt der Gehäusekappe (2) selbsthaltend eingesetzt ist.

4. Elektrizitätszähler nach einem der Ansprüche 1 bis 3, dadurch gekennzeichnet, daß die Kammer (2b) zum Einbau eines Rundsteuerempfängers ausgebildet ist.

5. Elektrizitätszähler nach einem der Ansprüche 1 bis 3, dadurch gekennzeichnet, daß die Kammer (2b) mit einem Tarifschaltuhren-Baustein versehen ist.

6. Elektrizitätszähler nach einem der Ansprüche 1 bis 3, dadurch gekennzeichnet, daß die Kammer (2b) für die Aufnahme von elektronischen Kommunikationsbausteinen, beispielsweise einem Temex-Modul, einem Bus-Anschlußsystem oder ähnlichen Geräten ausgebildet ist.

7. Elektrizitätszähler, insbesondere Drehstromzähler, nach einem der Ansprüche 1 bis 6, dadurch gekennzeichnet, daß die Kammer (2b) über die gesamte Breite der Gehäusekappe (2) und auf etwa einem Drittel der Gehäuselänge angeordnet ist.

8. Elektrizitätszähler nach Anspruch 7, dadurch gekennzeichnet, daß die Kammer (2b) im unteren Bereich der Gehäusekappe (2) zwischen einem Sichtfenster (2a) und einem Klemmenblockbereich (1a) angeordnet ist.

9. Elektrizitätszähler nach Anspruch 7, dadurch gekennzeichnet, daß die Kammer (2b) zwischen zwei Läuferscheiben des Triebsystems in der Gehäusekappe (2) angeordnet ist.

10. Elektrizitätszähler nach Anspruch 7, dadurch gekennzeichnet, daß die Kammer (2b) an der Oberseite des Zählergehäuses (3) in der Gehäusekappe (2) angeordnet ist.

11. Elektrizitätszähler nach einem der Ansprüche 1 bis 10, dadurch gekennzeichnet, daß die Kammer (2b) umlaufend mit einer labyrinthartigen Randausbildung (2d) versehen ist.

12. Elektrizitätszähler nach einem der Ansprüche 1 bis 11, dadurch gekennzeichnet, daß der Übergang vom Abdeckteil (4) zur Gehäusekappe (2) an der Frontseite des Zählergehäuses (3) oberflächenbündig mit dem nicht vertieften Teilbereich (2') der Gehäusekappe ausgebildet ist.

13. Elektrizitätszähler nach einem der Ansprüche 1 bis 12, dadurch gekennzeichnet, daß in der Trennwand (2c) der Kammer (2b) Durchführungen für Steckverbindungen (5a bzw. 6a) zum Innenraum (3a) des Zählergehäuses (3) angeordnet sind.

14. Elektrizitätszähler nach einem der Ansprüche 1 bis 13, dadurch gekennzeichnet, daß die Kammer (2b) einen Durchsteckschlitz für eine im Innenraum (3a) des Zählergehäuses (3) angeordnete, mit dem Meßwerk bzw. den Zähleranschlußklemmen in Wirkverbindung befindliche Schaltungsplatine (6) aufweist, deren in die Kammer (2b) vorstehender Teil als Steckverbindung (Kontaktflächen 6a) ausgebildet ist.

15. Elektrizitätszähler nach einem der Ansprüche 1 bis 14, dadurch gekennzeichnet, daß der vorstehende Teil der Schaltungsplatine (6) zwischen den Kontaktflächen (6a) kammartige Ausnehmungen (6c) aufweist, die als Freimachungen für Querstege eines auf die Schaltungsplatine (6) aufschiebbaren rahmenförmigen Dichtelementes (6b) ausgebildet sind.

16. Elektrizitätszähler nach einem der Ansprüche 1 bis 15, dadurch gekennzeichnet, daß die Kammer (2b) aus einem transparenten, eine optoelektronische Abtastung der Läuferscheibenmarke ermöglichenden Werkstoff hergestellt ist.

17. Elektrizitätszähler nach einem der Ansprüche 1 bis 15, dadurch gekennzeichnet, daß die Materialdicke der Trennwand (2c) zwischen der Kammer (2b) und dem Innenraum (3a) des Zählergehäuses (3) für eine induktive Abtastung ausgelegt ist.

18. Elektrizitätszähler nach einem der Ansprüche 1 bis 17, dadurch gekennzeichnet, daß das Abdeckteil (4) aus transparentem Werkstoff hergestellt ist.

19. Elektrizitätszähler nach einem der Ansprüche 1 bis 18, dadurch gekennzeichnet, daß das Abdeckteil (4) mittels Plombierschrauben (3c) für sich plombierbar ist.

Fig. 1

Fig. 2